# EUROPEAN PATENT APPLICATION

(11) **EP 2 434 731 A1**
(43) Date of publication of application: **28.03.2012**
(21) Application number: 11181488.5
(22) Date of filing: 15.09.2011
(51) Int. Cl.: H04M 1/02, G02F 1/1333, H01L 27/32

(54) **Display panel and method of manufacturing same**

(30) Priority: 28.09.2010 KR 20100093556; 11.05.2011 KR 20110043754
(71) Applicant: SAMSUNG ELECTRONICS CO., LTD., Suwon-si, Gyeonggi-do (KR)
(72) Inventor: Park, Ki Yeon, Gyeonggi-do (KR); Park, Tae Sang, Gyeonggi-do (KR); Park, Min Young, Gyeonggi-do (KR); Kim, Kun Tak, Gyeonggi-do (KR)
(74) Representative: Jenkins, Richard Gavin

(57) **Abstract**

A display panel (100) and a method of manufacturing the same are provided. The display panel (100) includes a plurality of chip panels (110,130), each chip panel having an upper surface (113,133), a lower surface (111,131) disposed parallel to the upper surface, a side surface (115,135) between the upper surface and the lower surface and a connection portion (117,137) between the side surface and at least one of the upper surface and the lower surface, the connection portion having a rounded configuration, and an adhesive layer (120) interposed between the chip panels in order to vertically stack the chip panels to connect the chip panels. Therefore, in the display panel, the strength of the edge portion can be improved. Also, by forming a connection portion, a stress can be suppressed from being concentrated at the edge portion by an external mechanical stress.

## Description

### BACKGROUND OF THE INVENTION

### 1. Field of the Invention:

The present invention relates to a mobile terminal and a method of manufacturing the same. More particularly, the present invention relates to a display panel of a mobile terminal and a method of manufacturing the same.

### 2. Description of the Related Art:

In general, as various functions are being added to mobile terminals, the mobile terminals now perform a variety of complex functions. For example, mobile terminals now provide various convenience functions such as a communication function, a message transmission and reception function, a wireless Internet function, a phonebook management function, a schedule management function, a memo management function, a navigation function, and the like. The mobile terminal has a display panel to perform a complex function. That is, the mobile terminal displays images according to execution of various functions through the display panel. Typically, the display panel is formed having a flat panel structure. In this case, the display panel should have at least a minimal level of strength.

However, in the mobile terminal, an edge portion of the display panel has remarkably lower strength than a central portion thereof. Thereby, when a mechanical stress is applied from the outside, a crack may occur at the edge portion of the display panel. When a crack occurs at the edge portion, the crack may be spread from the edge portion to the central portion. Accordingly, there is a need for an improved display panel and a method of making the same.

### SUMMARY OF THE INVENTION

Aspects of the present invention are to address the above-mentioned problems and/or disadvantages and to provide at least the advantages described below. Accordingly, an aspect of the present invention is to provide a display panel of a mobile terminal and a method of manufacturing the same that can suppress a crack from occurring in the display panel.

Another aspect of the present invention is to provide a display panel of a mobile terminal and a method of manufacturing the same that can suppress a transition of a crack from an edge portion to a central portion by suppressing a crack from occurring at the edge portion of the display panel.

In accordance with an aspect of the invention, a display panel is provided. The display panel includes a plurality of chip panels, each chip panel having an upper surface, a lower surface disposed parallel to the upper surface, a side surface between the upper surface and the lower surface, and a connection portion between the side surface and at least one of the upper surface and the lower surface, the connection portion having a rounded configuration, and an adhesive layer interposed between the chip panels in order to vertically stack the chip panels and to connect the chip panels.

In accordance with another aspect of the invention, a method of manufacturing a display panel is provided. The method includes preparing a plurality of chip panels, each chip panel having an upper surface, a lower surface disposed parallel to the upper surface, and a side surface between the upper surface and the lower surface, forming a connection portion between the side surface and at least one of the upper surface and the lower surface in each of the chip panels, and vertically stacking the plurality of chip panels by interposing an adhesive layer between the chip panels.

According to an exemplary display panel and a method of manufacturing the same of the present invention, the strength of the edge portion of the display panel can be improved. That is, by forming a connection portion at the edge portion of the display panel, stress can be suppressed from being concentrated at the edge portion of the display panel by an external mechanical stress. Thereby, when an external mechanical stress is applied, a crack can be suppressed from occurring at the edge portion of the display panel. Also, a crack can be suppressed from spreading from the edge portion to a central portion.

Other aspects, advantages, and salient features of the invention will become apparent to those skilled in the art from the following detailed description, which, taken in conjunction with the annexed drawings, discloses exemplary embodiments of the invention.

### BRIEF DESCRIPTION OF THE DRAWINGS

The above and other aspects, features, and advantages of the present invention will be more apparent from the following description taken in conjunction with the accompanying drawings, in which:

FIG. 1(A) is a perspective view illustrating a display panel according to a first exemplary embodiment of the present invention;

FIG. 1(B) is a cross-sectional view along line B-B' of FIG. 1(A) illustrating a display panel according to a first exemplary embodiment of the present invention;

FIG. 2 is a cross-sectional view illustrating a display panel according to a second exemplary embodiment of the present invention;

FIG. 3 is a cross-sectional view illustrating a display panel according to a third exemplary embodiment of the present invention;

FIG. 4 is a cross-sectional view illustrating a display panel according to a fourth exemplary embodiment of the present invention;

FIG. 5 is a cross-sectional view illustrating a display panel according to a fifth exemplary embodiment of the present invention;

FIG. 6 is a cross-sectional view illustrating a display panel according to a sixth exemplary embodiment of the present invention;

FIGs. 7(A) and 7(B) are graphs illustrating an operation characteristic of a display panel according to the related art and according to an exemplary embodiment of the present invention;

FIGs. 8(A) - 8(C) are diagrams illustrating modified examples of a display panel according to exemplary embodiments of the present invention; and

FIG. 9 is a flowchart illustrating a process of a method of manufacturing a display panel according to exemplary embodiments of the present invention.

Throughout the drawings, it should be noted that like reference numbers are used to depict the same or similar elements, features, and structures.

### DETAILED DESCRIPTION OF EXEMPLARY EMBODIMENTS

The following description with reference to the accompanying drawings is provided to assist in a comprehensive understanding of exemplary embodiments of the invention as defined by the claims and their equivalents. It includes various specific details to assist in that understanding but these are to be regarded as merely exemplary. Accordingly, those of ordinary skill in the art will recognize that various changes and modifications of the embodiments described herein can be made without departing from the scope and spirit of the invention. In addition, descriptions of well-known functions and constructions may be omitted for clarity and conciseness.

The terms and words used in the following description and claims are not limited to the bibliographical meanings, but, are merely used by the inventor to enable a clear and consistent understanding of the invention. Accordingly, it should be apparent to those skilled in the art that the following description of exemplary embodiments of the present invention is provided for illustration purpose only and not for the purpose of limiting the invention as defined by the appended claims and their equivalents.

It is to be understood that the singular forms "a," "an," and "the" include plural referents unless the context clearly dictates otherwise. Thus, for example, reference to "a component surface" includes reference to one or more of such surfaces.

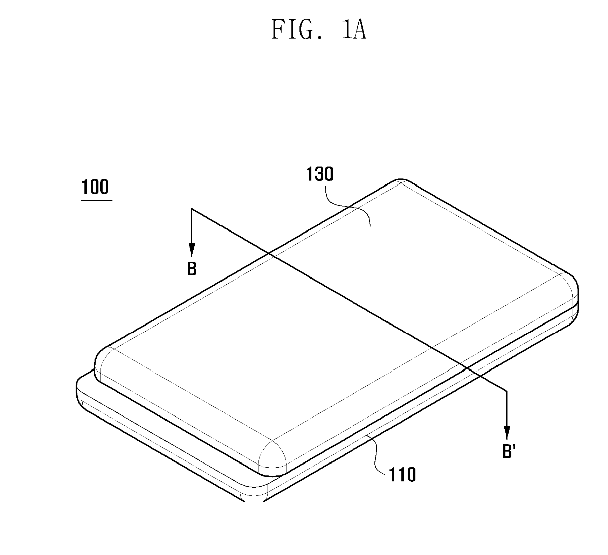

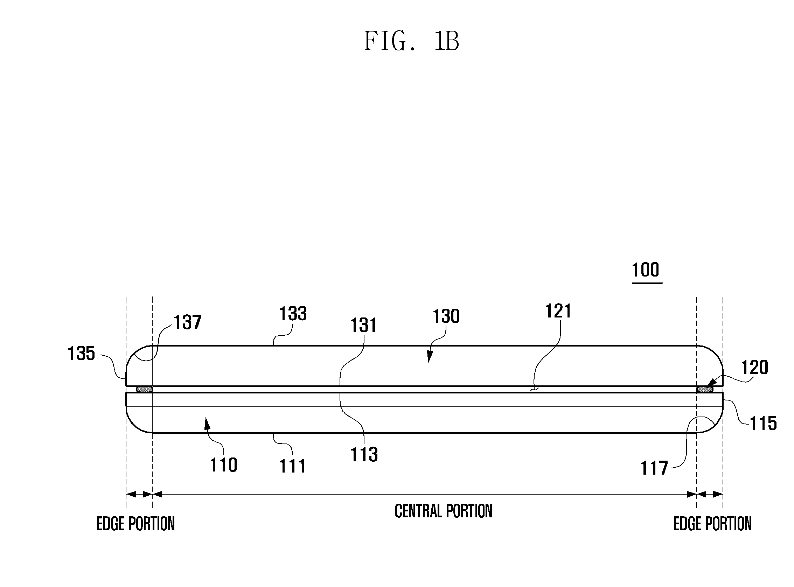

FIG. 1(A) is a perspective view illustrating a display panel according to a first exemplary embodiment of the present invention, and FIG. 1(B) is a cross-sectional view along line B-B' of FIG. 1(A) illustrating a display panel according to a first exemplary embodiment of the present invention.

Referring to FIGs. 1(A) and 1(B), a display panel 100 includes a lower chip panel 110, an adhesive layer 120, and an upper chip panel 130. In the present exemplary embodiment, the display panel 100 is formed with an Active Matrix Organic Light Emitting Diode (AMOLED), however the display panel 100 is not limited thereto.

The lower chip panel 110 is formed in a flat panel structure. In this case, the lower chip panel 110 is formed with a Low Temperature Polysilicon (LTPS). The lower chip panel 110 has a lower surface 111, an upper surface 113 disposed parallel to the lower surface 111, and a side surface 115 between the lower surface 111 and the upper surface 113 for vertically connecting edge portions of the lower surface 111 and the upper surface 113. In the lower chip panel 110, the lower surface 111 and the upper surface 113 are formed in a rectangular shape.

In the lower chip panel 110, a connection portion 117 having a curved shape is formed between the lower surface 111 and the side surface 115. In the lower chip panel 110 illustrated in FIG. 1(B), the connection portion 117 is formed in an embossed shape i.e., in a convex shape in which a central area is further protruded from the inside to the outside than a circumferential area. Thereby, when an external mechanical stress is applied to the connection portion 117 of the lower chip panel 110, the stress is distributed from an edge portion to a central portion. That is, by means of the connection portion 117 of the lower chip panel 110, a crack is suppressed from occurring at the edge portion and, if a crack does occur, the crack is delayed from spreading from the edge portion to the central portion.

The adhesive layer 120 is formed in a loop form. The adhesive layer 120 is disposed at the upper surface 113 of the lower chip panel 110. Here, the adhesive layer 120 is disposed at an area adjacent to the edge portion in the upper surface 113 of the lower chip panel 110. In this case, an inner area 121 is formed in the adhesive layer 120. Here, the inner area 121 may be in a vacuum state or filled with a specific gas, for example a nitrogen gas (e.g., N₂).

The upper chip panel 130 is formed in a flat panel structure. In an exemplary implementation, the upper chip panel 130 is formed with glass. Here, the upper chip panel 130 may be formed having the same size as that of the lower chip panel 110 or may be formed having a size different from that of the lower chip panel 110. The upper chip panel 130 is stacked at an upper part of the lower chip panel 110 via the adhesive layer 120. The upper chip panel 130 has a lower surface 131, an upper surface 133 disposed parallel to the lower surface 131, and a side surface 135 between the lower surface 131 and the upper surface 133 for vertically connecting edge portions of the lower surface 131 and the upper surface 133. The upper chip panel 130 is stacked in an upper part of the lower chip panel 110 through the lower surface 131. Here, in the upper chip panel 130, the lower surface 131 and the upper surface 133 are formed in a rectangular shape.

In this case, in the upper chip panel 130, a connection portion 137 having a curved shape is formed between the upper surface 133 and the side surface 135. Here, in the upper chip panel 130, the connection portion 137 is formed in an embossed shape i.e., in a convex shape in which a central area is further protruded from the inside to the outside than a circumferential area. Thereby, when an external mechanical stress is applied, the stress is distributed from the edge portion to the central portion by the connection portion 137 of the upper chip panel 130. That is, by means of the connection portion 137 of the upper chip panel 130, a crack is suppressed from occurring at the edge portion and, if a crack does occur, the crack is delayed from spreading from the edge portion to the central portion.

In the present exemplary embodiment, the lower chip panel 110 and the upper chip panel 130 are stacked in a symmetrical shape using the adhesive layer 120 as a boundary. That is, as the connection portions 117 and 137 correspond to the lower surface 111 of the lower chip panel 110 and the upper surface 133 of the upper chip panel 130, respectively, the lower chip panel 110 and the upper chip panel 130 are stacked in a symmetrical structure. As the lower surface 111 of the lower chip panel 110, the upper surface 133 of the upper chip panel 130, and the adhesive layer 120 form an outer wall, a vacuum state or a specific gas-filled state is sustained in an inner area 121 of the adhesive layer 120. In this case, when an external mechanical stress is applied, the connection portions 117 and 137 of the lower chip panel 110 and the upper chip panel 130, respectively, distribute the stress from the edge portion to the central portion. Thereby, the stress applied to the adhesive layer 120 is reduced and thus a crack is suppressed from occurring in the adhesive layer 120. Accordingly, reliability of the display panel 100 is improved.

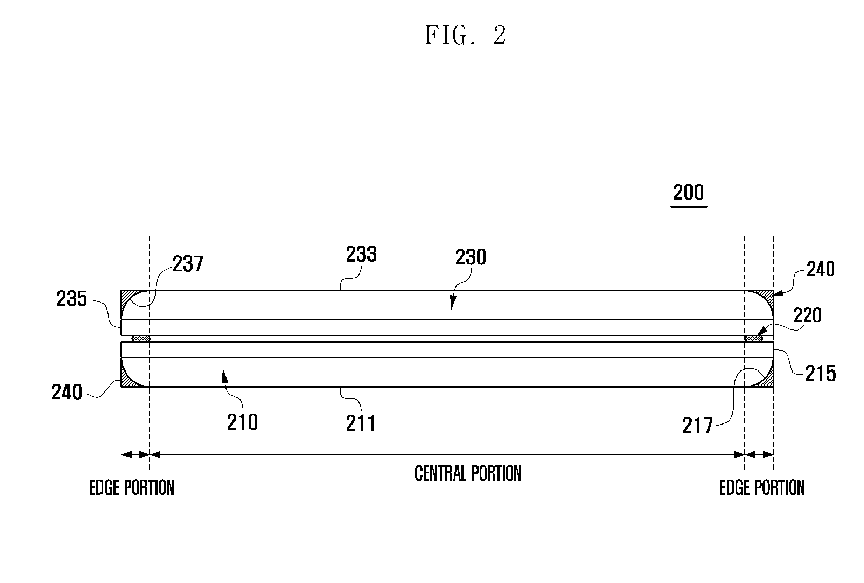

FIG. 2 is a cross-sectional view illustrating a display panel according to a second exemplary embodiment of the present invention.

Referring to FIG. 2, a display panel 200 includes a lower chip panel 210, adhesive layer 220, upper chip panel 230, and resin bonding portion 240. In this case, the display panel 200 is similar to the display panel of the foregoing exemplary embodiment and therefore a detailed description thereof is omitted. However, the display panel 200 according to the present exemplary embodiment further includes a resin bonding portion 240, compared with the display panel of the foregoing exemplary embodiment.

The resin bonding portion 240 includes connection portions 217 and 237 in the display panel 200. Here, the resin bonding portion 240 bonds to the connection portion 217 between a lower surface 211 and a side surface 215 of the lower chip panel 210. The resin bonding portion 240 also bonds to the connection portion 237 between an upper surface 233 and a side surface 235 of the upper chip panel 230. The resin bonding portion 240 performs a function of protecting an edge portion of the lower chip panel 210 and the upper chip panel 230 from an external mechanical stress. Further, the resin bonding portion 240 performs a function of sustaining the lower chip panel 210 and the upper chip panel 230 in a shape before the connection portions 217 and 237 are formed. For this, the resin bonding portion 240 is formed with a material having higher adhesive strength. For example, the resin bonding portion 240 may be formed with an epoxy resin.

Thereby, the resin bonding portion 240 improves the strength of an edge portion in the lower chip panel 210 and the upper chip panel 230. That is, the resin bonding portion 240 suppresses a crack from occurring in an edge portion of the lower chip panel 210 and the upper chip panel 230 and delays a crack from spreading to a central portion in the lower chip panel 210 and the upper chip panel 230. Further, the resin bonding portion 240 suppresses a crack from occurring in the adhesive layer 220 by reducing a stress applied to the adhesive layer 220. Accordingly, reliability of the display panel 200 is improved.

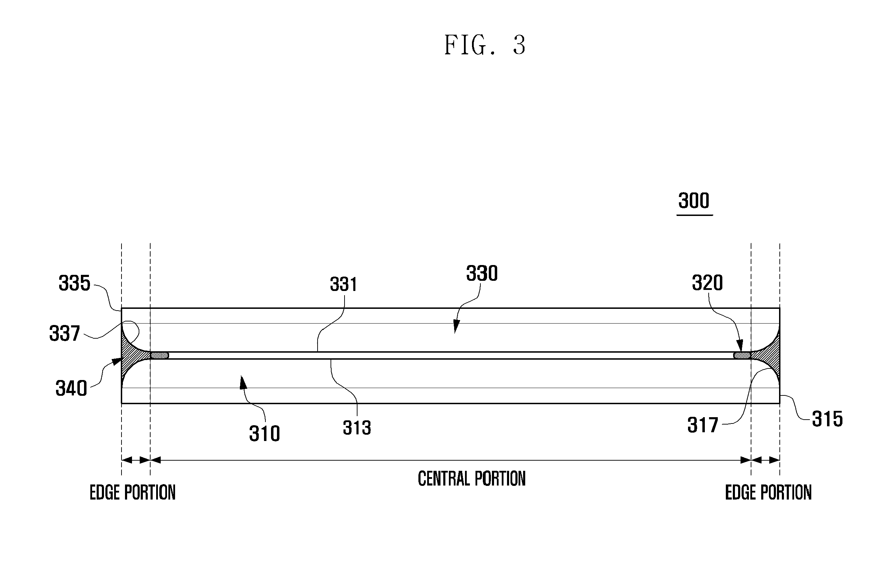

FIG. 3 is a cross-sectional view illustrating a display panel according to a third exemplary embodiment of the present invention.

Referring to FIG. 3, a display panel 300 includes a lower chip panel 310, adhesive layer 320, and upper chip panel 330. In this case, the display panel 300 further includes a resin bonding portion 340. Here, the display panel 300 according to the present exemplary embodiment is similar to the display panel of the foregoing exemplary embodiment and therefore a detailed description thereof is omitted. However, the display panel 300 according to the present exemplary embodiment has connection portions 317 and 337 in a position different from the display panel of the foregoing exemplary embodiment.

In the lower chip panel 310, the connection portion 317 having a curved shape is formed between an upper surface 313 and a side surface 315. In the upper chip panel 330, the connection portion 337 having a curved shape is formed between a lower surface 331 and a side surface 335. Further, the resin bonding portion 340 bonds to the connection portion 317 between the upper surface 313 and the side surface 315 of the lower chip panel 310. Also, the resin bonding portion 340 bonds to the connection portion 337 between a lower surface 331 and the side surface 335 of the upper chip panel 330.

Thereby, when an external mechanical stress is applied at the connection portions 317 and 337 of the lower chip panel 310 and the upper chip panel 330, respectively, the stress is distributed from the edge portion to a central portion. That is, the connection portions 317 and 337 of the lower chip panel 310 and the upper chip panel 330, respectively, suppress a crack from occurring in the edge portion and delay the crack from spreading from the edge portion to the central portion. Further, as the stress applied to the adhesive layer 320 is reduced, a crack is suppressed from occurring in the adhesive layer 320. Accordingly, reliability of the display panel 300 is improved.

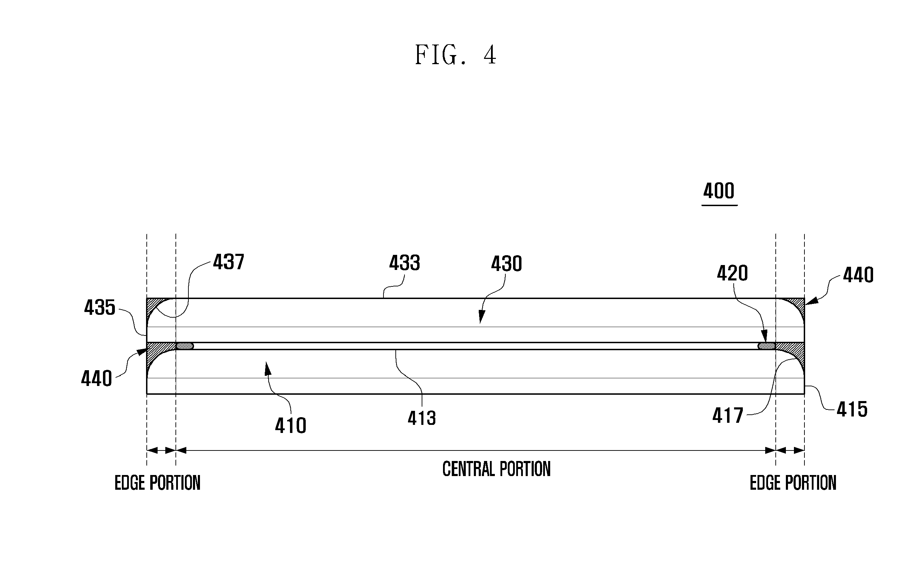

FIG. 4 is a cross-sectional view illustrating a display panel according to a fourth exemplary embodiment of the present invention.

Referring to FIG. 4, a display panel 400 includes a lower chip panel 410, adhesive layer 420, and upper chip panel 430. In this case, the display panel 400 further includes a resin bonding portion 440. In this case, the display panel 400 according to the present exemplary embodiment is similar to the display panel of the foregoing exemplary embodiment and therefore a detailed description thereof is omitted. However, the display panel 400 according to the present exemplary embodiment has connection portions 417 and 437 in a position different from the display panel of the foregoing exemplary embodiment.

In the lower chip panel 410, the connection portion 417 having a curved shape is formed between an upper surface 413 and a side surface 415. In the upper chip panel 430, the connection portion 437 having a curved shape is formed between the upper surface 433 and a side surface 435. Further, the resin bonding portion 440 bonds to the connection portion 417 between the upper surface 413 and the side surface 415 of the lower chip panel 410. Also, the resin bonding portion 440 bonds to the connection portion 437 between the upper surface 433 and the side surface 435 of the upper chip panel 430.

Thereby, when an external mechanical stress is applied at the connection portions 417 and 437 of the lower chip panel 410 and the upper chip panel 430, respectively, the stress is distributed from an edge portion to a central portion. That is, the connection portions 417 and 437 of the lower chip panel 410 and the upper chip panel 430, respectively, suppress a crack from occurring in the edge portion and delay the crack from spreading from the edge portion to the central portion. Further, as the stress applied to the adhesive layer 420 is reduced, a crack is suppressed from occurring in the adhesive layer 420. Accordingly, reliability of the display panel 400 is improved.

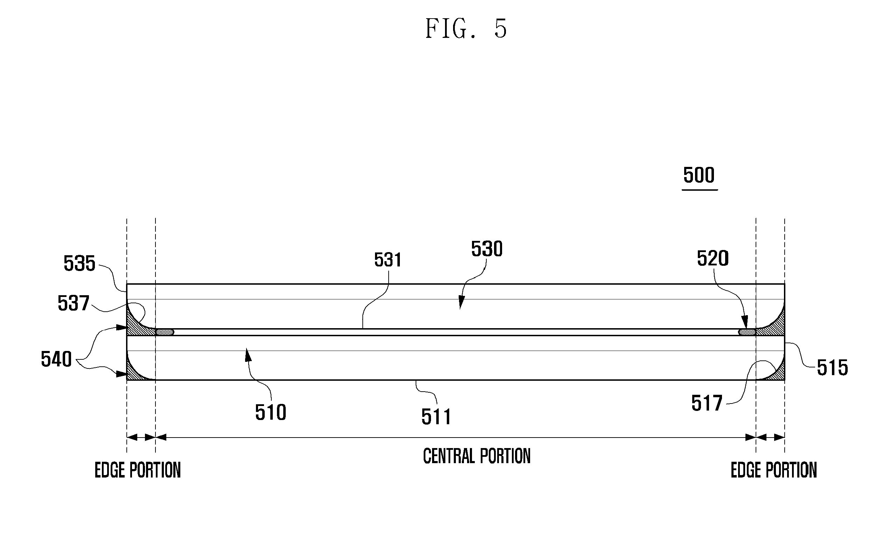

FIG. 5 is a cross-sectional view illustrating a display panel according to a fifth exemplary embodiment of the present invention.

Referring to FIG. 5, a display panel 500 includes a lower chip panel 510, adhesive layer 520, and upper chip panel 530. In this case, the display panel 500 further includes a resin bonding portion 540. Here, the display panel 500 according to the present exemplary embodiment is similar to the display panel of the foregoing exemplary embodiment and therefore a detailed description thereof is omitted. However, the display panel 500 according to the present exemplary embodiment has connection portions 517 and 537 in a position different from the display panel of the foregoing exemplary embodiment.

In the lower chip panel 510, the connection portion 517 having a curved shape is formed between a lower surface 511 and a side surface 515. In the upper chip panel 530, the connection portion 537 having a curved shape is formed between a lower surface 531 and a side surface 535. Further, the resin bonding portion 540 bonds to the connection portion 517 between the lower surface 511 and the side surface 515 of the lower chip panel 510. Also, the resin bonding portion 540 bonds to the connection portion 537 between the lower surface 531 and the side surface 535 of the upper chip panel 530.

Thereby, when an external mechanical stress is applied, the stress is distributed from an edge portion to a central portion by the connection portions 517 and 537 of the lower chip panel 510 and the upper chip panel 530, respectively. That is, the connection portions 517 and 537 of the lower chip panel 510 and the upper chip panel 530, respectively, suppress a crack from occurring in the edge portion and delay the crack from spreading from the edge portion to the central portion. Further, as the stress applied to the adhesive layer 520 is reduced, a crack is suppressed from occurring in the adhesive layer 520. Accordingly, reliability of the display panel 500 is improved.

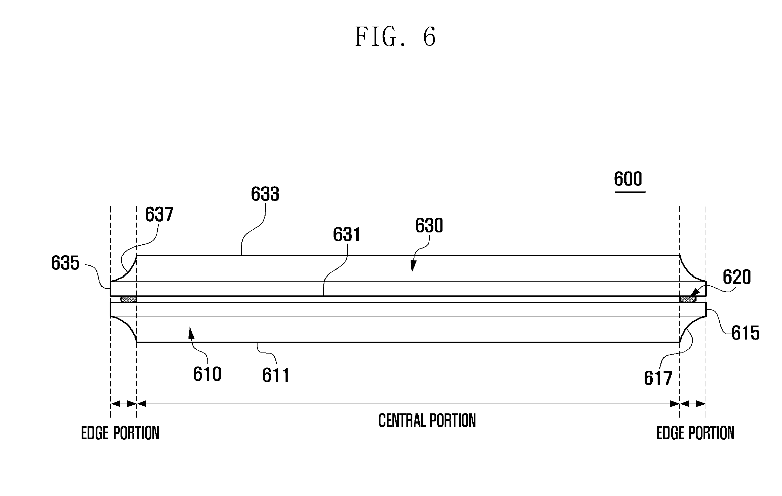

FIG. 6 is a cross-sectional view illustrating a display panel according to a sixth exemplary embodiment of the present invention.

Referring to FIG. 6, a display panel 600 includes a lower chip panel 610, adhesive layer 620, and upper chip panel 630. Although not shown in FIG. 6, the display panel 600 further includes a resin bonding portion. In this case, the display panel 600 according to the present exemplary embodiment is similar to the display panels of the foregoing exemplary embodiments and therefore a detailed description thereof is omitted. However, the display panel 600 according to the present exemplary embodiment has connection portions 617 and 637 of a form different from that of the foregoing exemplary embodiment.

In the lower chip panel 610, the connection portion 617 having a curved shape is formed between a lower surface 611 and a side surface 615. Here, in the lower chip panel 610, the connection portion 617 is formed in a depressed shape i.e., in a recess shape in which a central area is further receded from the outside to the inside than a circumferential area. In the upper chip panel 630, the connection portion 637 having a curved shape is formed between an upper surface 633 and a side surface 635. Here, in the upper chip panel 630, the connection portion 637 is formed in a depressed shape i.e., in a recess shape in which a central area is further receded from the outside to the inside than a circumferential area.

The present exemplary embodiment illustrates an example in which the connection portion 617 is formed between the lower surface 611 and the side surface 615 of the lower chip panel 610. However, a formed position of the connection portion 617 is not limited thereto. That is, the connection portion 617 can be formed between an upper surface 613 and the side surface 615 of the lower chip panel 610. Further, the present exemplary embodiment illustrates an example in which the connection portion 637 is formed between the upper surface 633 and the side surface 635 of the upper chip panel 630. However, a formed position of the connection portion 637 is not limited thereto. That is, the connection portion 637 can be formed between the lower surface 631 and the side surface 635 of the upper chip panel 630.

Thereby, when an external mechanical stress is applied, the stress is distributed from an edge portion to a central portion by the connection portions 617 and 637 of the lower chip panel 610 and the upper chip panel 630, respectively. That is, the connection portions 617 and 637 of the lower chip panel 610 and the upper chip panel 630, respectively, suppress a crack from occurring in the edge portion and delay the crack from spreading from the edge portion to the central portion. Further, as the stress applied to the adhesive layer 620 is reduced, a crack is suppressed from occurring in the adhesive layer 620. Accordingly, reliability of the display panel 600 is improved.

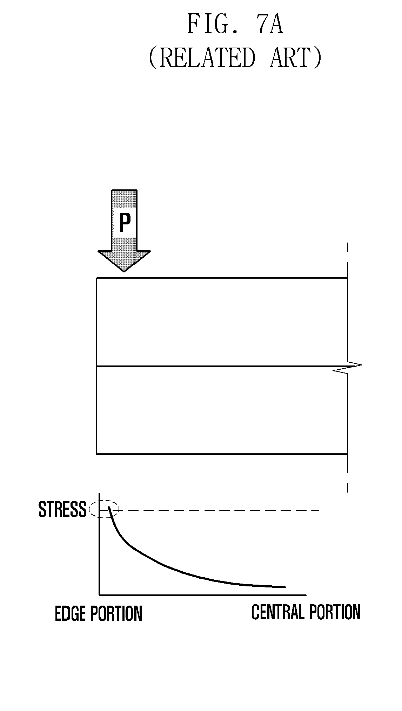

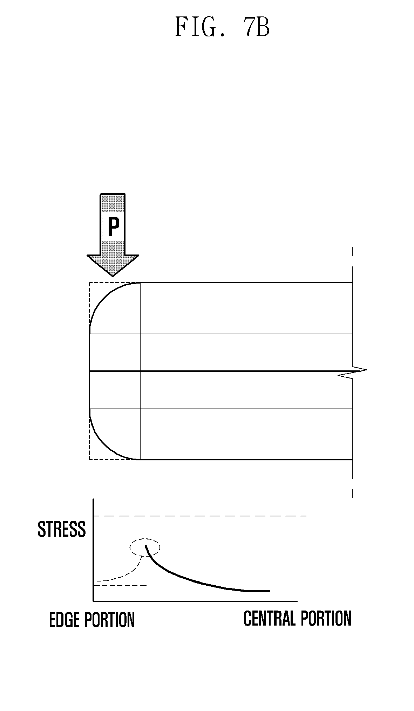

FIGs. 7(A) and 7(B) are graphs illustrating an operation characteristic of a display panel according to the related art and according to exemplary embodiments of the present invention.

Further, FIGs. 7(A) and 7(B) are graphs illustrating a partial stress concentration degree in the display panel. Here, FIG. 7(A) is a graph corresponding to a display panel of the related art, and FIG. 7(B) is a graph corresponding to the display panel according to an exemplary embodiment of the present invention.

Referring to FIG. 7(A), in a display panel of the related art, when an external mechanical stress is applied at an edge portion, the stress is concentrated at the edge portion. Referring to FIG. 7(B), in a display panel according to an exemplary embodiment of the present invention, when an external mechanical stress is applied at an edge portion, the stress is not concentrated at the edge portion. Thereby, the probability of a crack at the edge portion of the display panel according to the present exemplary embodiment is lower than the probability of a crack at the edge portion of the display panel of the related art. This is because a connection portion is formed in a convex shape or a recess shape in the display panel according to the present exemplary embodiments and thus a stress is distributed from the edge portion of the display panel to a central portion.

That is, due to the connection portion of the display panel, a crack is suppressed from occurring in the edge portion of the display panel according to the present exemplary embodiments, and a crack is delayed from spreading from the edge portion to the central portion. Further, as a stress to be applied to an adhesive layer is reduced, a crack is suppressed from occurring in the adhesive layer. In this case, in the display panel, as a resin bonding portion includes a connection portion, the probability of a crack is further deteriorated in the edge portion of the display panel according to the present exemplary embodiments. Accordingly, reliability of the display panel can be improved.

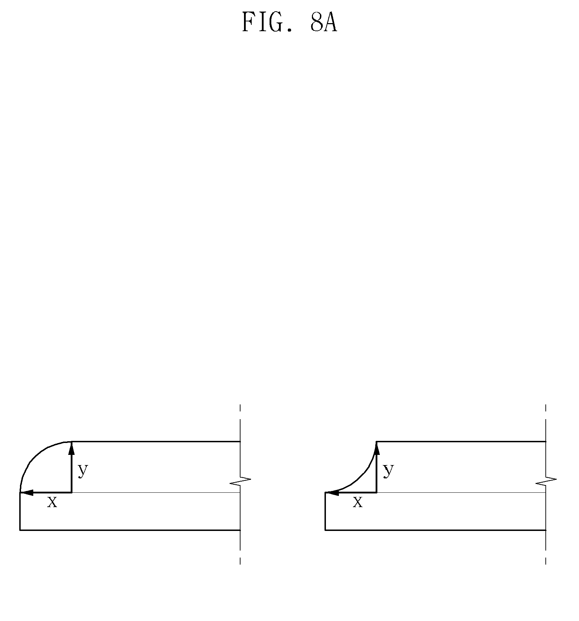

FIGs. 8(A) - 8(C) are diagrams illustrating modified examples of a display panel according to exemplary embodiments of the present invention.

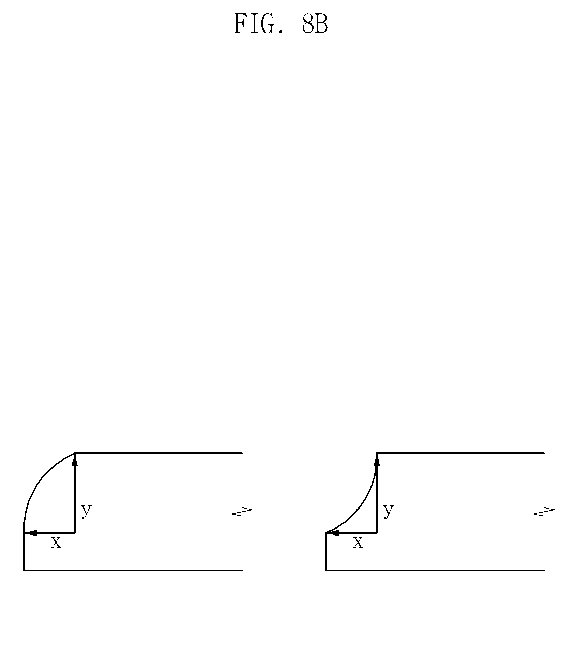

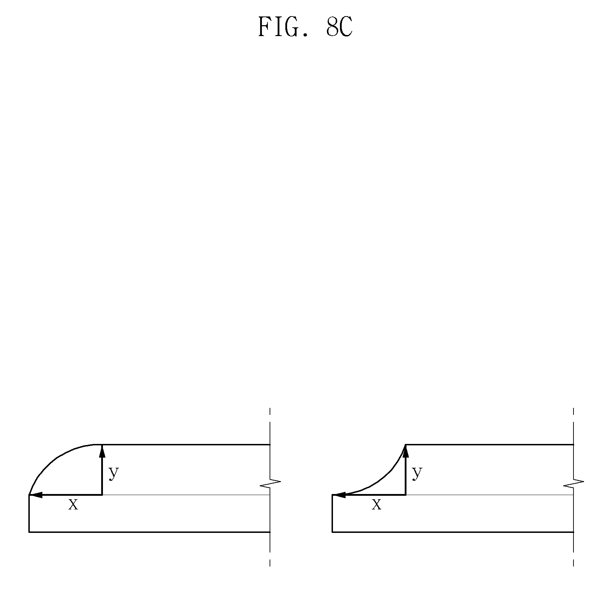

Referring to FIGs. 8(A) - 8(C), in the display panel according to the present exemplary embodiments, a connection portion is formed in a predetermined horizontal length x and a predetermined vertical length y. As shown in FIG. 8(A), the connection portion has the same horizontal length and vertical length. Alternatively, as shown in FIG. 8(B), the connection portion may have a vertical length longer than a horizontal length. Alternatively, as shown in FIG. 8(C), the connection portion may have a vertical length shorter than a horizontal length. Here, the horizontal length and the vertical length of the connection portion can be determined according to a design structure such as a thickness and an area of the display panel, and a structure and a position of space in which the display panel is mounted.

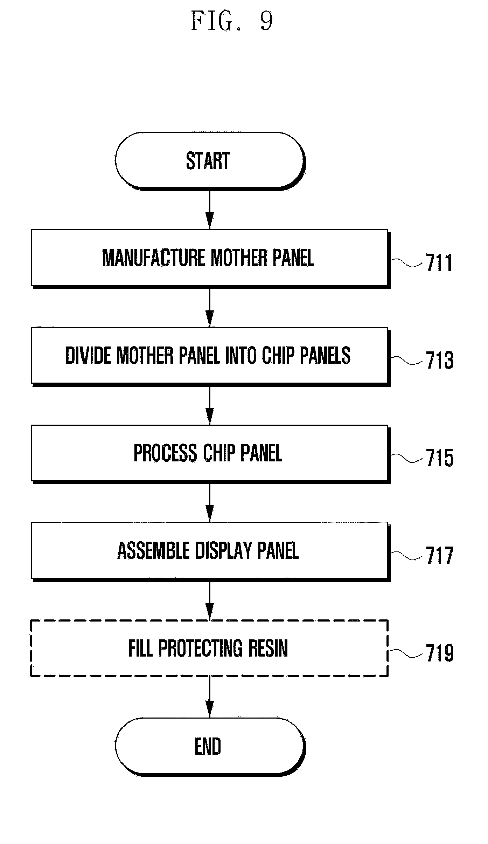

FIG. 9 is a flowchart illustrating a method of manufacturing a display panel according to an exemplary embodiment of the present invention.

Referring to FIG. 9, in a process of manufacturing a display panel, a mother panel is first manufactured in step 711. Here, the mother panel is formed in a flat panel structure. In this case, mother panels for each of an upper chip panel and a lower chip panel are manufactured. Here, the mother panel for the upper chip panel may be formed with glass, and the lower chip panel may be formed with low temperature polysilicon.

The mother panel is divided into a plurality of chip panels in step 713. Here, the chip panel includes at least one of an upper chip panel and a lower chip panel. That is, by cutting each of the mother panels, the upper chip panel and the lower chip panel are separated from the mother panels. In this case, each of the upper chip panel and the lower chip panel has an upper surface, a lower surface, and a side surface.

Each chip panel is processed in step 715. In this case, a connection portion is formed in an edge portion of the chip panel. That is, in each of the upper chip panel and the lower chip panel, a connection portion is formed between a side surface and at least one of an upper surface and a lower surface. Here, when a crack is formed in the edge portion of the chip panel by cutting the mother panel, the crack is removed by processing the edge portion of the chip panel.

The display panel is assembled with the chip panels in step 717. In this case, by interposing an adhesive layer between the chip panels, the chip panels are vertically stacked. Here, in a space having a vacuum state or a state filled with a specific gas, for example a nitrogen gas, the display panel is assembled with the chip panels.

For example, after adhesives are coated in a loop form at an upper surface of a lower chip panel, upper chip panels can be stacked at an upper part of the lower chip panel using the adhesives as a boundary. Thereafter, by melting the adhesives, for example with a laser, the lower chip panel and the upper chip panel can be bonded using the adhesives. Further, an adhesive layer is formed between the lower chip panel and the upper chip panel, and an inner area is formed in the adhesive layer. Alternatively, after adhesives are coated in a loop form at an upper surface of the lower chip panel, the adhesives are melted, for example by a laser. Thereafter, by stacking upper chip panels at an upper part of the lower chip panel using adhesives as a boundary, the lower chip panel and the upper chip panel are bonded using the adhesives. Further, an adhesive layer is formed between the lower chip panel and the upper chip panel, and an inner area is formed at the adhesive layer.

A resin bonding portion is further formed in step 719. In the display panel, by filling a protection resin in a peripheral area of a connection portion, the resin bonding portion is formed in the display panel. Here, the protection resin may be an epoxy resin. In this case, in order for the display panel to sustain a shape before the connection portion is formed, the resin bonding portion may be formed in the display panel.

In the foregoing exemplary embodiments, the display panel is an AMOLED, but the display panel is not limited thereto. That is, even when the display panel is, for example, a Light Emitting Diode (LED) or a Liquid Crystal Display (LCD), by forming a connection portion in an edge portion of the display panel, a display panel according to the present invention can be obtained. For example, when the display panel is an LCD, an adhesive layer of the display panel has a flat panel form. Here, the adhesive layer is formed with liquid crystal. When the display panel is assembled, by injecting liquid crystal between an upper chip panel and a lower chip panel, the lower chip panel and the upper chip panel can be bonded using liquid crystal. Here, liquid crystal can be injected between the upper chip panel and the lower chip panel using an osmotic pressure method. Thereby, the upper chip panels are stacked at an upper part of the lower chip panel using liquid crystal as a boundary.

According to exemplary embodiments of the present invention, in a display panel, the strength of an edge portion can be improved. By forming a connection portion at the edge portion of the display panel, a stress can be suppressed from being concentrated at the edge portion of the display panel from an external mechanical stress. Further, by forming a resin bonding portion at the edge portion of the display panel, the strength of the edge portion of the display panel can be improved. Thereby, when an external mechanical stress is applied, a crack can be suppressed from occurring at the edge portion of the display panel and can be suppressed from spreading from the edge portion to a central portion of the display panel. Further, by reducing the stress applied to an adhesive layer, a crack can be suppressed from occurring at the adhesive layer. Accordingly, reliability of the display panel can be improved.

While the invention has been shown and described with reference to certain exemplary embodiments thereof, it will be understood by those skilled in the art that various changes in form and details may be made therein without departing from the spirit and scope of the invention as defined in the appended claims and their equivalents.

## Claims

1. A display panel comprising:
a plurality of chip panels, each chip panel having an upper surface, a lower surface disposed parallel to the upper surface, a side surface between the upper surface and the lower surface, and a connection portion between the side surface and at least one of the upper surface and the lower surface, the connection portion having a rounded configuration; and
an adhesive layer interposed between the chip panels in order to vertically stack the chip panels and to connect the chip panels.

2. The display panel of claim 1, further comprising a resin bonding portion bonded to the connection portion.

3. The display panel of claim 1, wherein the adhesive layer is interposed between edge portions at each of an upper surface of one of the chip panels and a lower surface of another one of the chip panels.

4. The display panel of claim 3, wherein an inner area formed by the adhesive layer between the chip panels is in one of a vacuum state and a gas-filled state.

5. The display panel of claim 1, wherein the chip panels have a symmetrical shape using the adhesive layer as a boundary.

6. The display panel of claim 1, wherein the chip panels have an asymmetrical shape using the adhesive layer as a boundary.

7. The display panel of claim 1, wherein the adhesive layer comprises a liquid crystal.

8. The display panel of claim 1, wherein the rounded configuration of the connection portion comprises at least one of a convex shape and a recess shape.

9. A method of manufacturing a display panel, the method comprising:
preparing a plurality of chip panels, each chip panel having an upper surface, a lower surface disposed parallel to the upper surface, and a side surface between the upper surface and the lower surface;
forming a connection portion between the side surface and at least one of the upper surface and the lower surface in each of the chip panels; and
vertically stacking the plurality of chip panels by interposing an adhesive layer between the chip panels.

10. The method of claim 9, further comprising forming a resin bonding portion bonded to the connection portion.

11. The method of claim 9, wherein the adhesive layer is interposed between edge portions at each of an upper surface of one of the chip panels and a lower surface of another one of the chip panels.

12. The method of claim 11, wherein the vertically stacking of the chip panels by interposing an adhesive layer between the chip panels is performed in a vacuum environment or a specific gas environment in order to make an inner area formed by the adhesive layer between the chip panels one of a vacuum state and a specific gas-filled state.

13. The method of claim 9, wherein the chip panels have a symmetrical shape or an asymmetric shape using the adhesive layer as a boundary.

14. The method of claim 9, wherein the adhesive layer comprises a liquid crystal.

15. The method of claim 9, wherein the forming of the connection portion between the side surface and at least one of the upper surface and the lower surface in each of the chip panels comprises forming the connection portion in at least one of a convex shape and a recess shape.
